# EUROPÄISCHE PATENTSCHRIFT

(11) **EP 3 536 134 B1**
(45) Veröffentlichungstag und Bekanntmachung des Hinweises auf die Patenterteilung: **20.01.2021**
(21) Anmeldenummer: 17801333.0
(22) Anmeldetag: 03.11.2017
(51) Int. Cl.: H05K 7/14, H05K 9/00

(54) **LEISTUNGSELEKTRONIKEINHEIT MIT EINEM EINE HOCHVOLTSEITE VON EINER NIEDERVOLTSEITE ENTKOPPELNDEN TRENNELEMENT**
POWER ELECTRONICS UNIT HAVING A SEPARATING ELEMENT DECOUPLING A HIGH-VOLTAGE SIDE FROM A LOW-VOLTAGE SIDE
UNITÉ ÉLECTRONIQUE DE PUISSANCE AVEC ÉLÉMENT DE SÉPARATION DÉCOUPLANT UN CÔTÉ HAUTE TENSION D'UN CÔTÉ BASSE TENSION

(30) Priorität: 07.11.2016 DE 102016221728
(43) Veröffentlichungstag der Anmeldung: 11.09.2019
(73) Patentinhaber: Schaeffler Technologies AG & Co. KG, 91074 Herzogenaurach (DE)
(72) Erfinder: BLAES, Cédric, 67470 Munchhausen (FR); PREISING, Stephan, 81245 München (DE); ECKSTEIN, Daniel, 77833 Ottersweier-Unzhurst (DE); TIPPER, Jürgen, 76593 Gernsbach (DE); GRAMANN, Nicolai, 77871 Renchen (DE)
(86) Internationale Anmeldenummer: PCT/DE2017/100929
(87) Internationale Veröffentlichungsnummer: WO 2018/082746

(56) Entgegenhaltungen:
- JP-A- H05 259 683
- US-A1- 2012 063 038
- US-A1- 2016 181 940

## Beschreibung

Die Erfindung betrifft eine Leistungselektronikeinheit (auch als Leistungselektronik vereinfacht bezeichnet), insbesondere für einen hybriden Antriebsstrang eines Kraftfahrzeuges, mit einem elektrisch leitenden / stromleitenden Gehäuse, in dem ein Niedervoltraumbereich sowie ein Hochvoltraumbereich ausgebildet sind, sowie mit einer Platine, die abschnittsweise sowohl in den Niedervoltraumbereich als auch in den Hochvoltraumbereich hinein ragt bzw. in diesen angeordnet ist. Des Weiteren betrifft die Erfindung ein elektrisches Antriebssystem, etwa ein Hybridsystem (z.B. in Form eines Hybridmoduls), eine E-Achse oder ähnliche Ausführungen, für ein Kraftfahrzeug, insbesondere für einen Antriebsstrang des Kraftfahrzeuges, mit einem Elektromotor und der mit dem Elektromotor elektrisch verbundenen Leistungselektronikeinheit.

Entfernter Stand der Technik ist aus der DE 10 2015 201 314 A1 bekannt. Hierin ist eine Leistungselektronik in einem Aktuator offenbart.

Desweiteren ist bekannt, zur elektromagnetischen Verträglichkeit auftretende Störungen durch entsprechende Maßnahmen zu beheben. Hierbei wird häufig eine leitungsgebundene Störung entsprechend durch geeignete Masseführung, durch Kabelabschirmung und entsprechende Filter minimiert.

Jedoch kann bei diesen bekannten Ausführungen das Problem auftreten, dass die beiden unterschiedlichen Spannungsräume, nämlich der Hochspannungs-/ Hochvoltraumbereich sowie der Niederspannungs-/ Niedervoltraumbereich, nicht vollständig genug voneinander abgeschirmt sind.

Aus der US 2016/0181940 A1 ist ein Leistungselektronikmodule gemäß dem Oberbegriff des Anspruchs 1 bekannt.

Bezüglich weiteren Standes der Technik wird auf die US 2012/063038 A1 und die JP H05 259683 A verwiesen.

Es ist daher die Aufgabe der vorliegenden Erfindung, diese aus dem Stand der Technik bekannten Nachteile zu beheben und insbesondere eine Leistungselektronikeinheit zur Verfügung zu stellen, bei der eine Beeinflussung zwischen einer Hochvoltseite sowie einer Niedervoltseite weiter reduziert werden soll.

Dies wird erfindungsgemäß dadurch gelöst, dass ein Trennelement derart in dem Gehäuse angeordnet ist sowie das Gehäuse und/oder die Platine mittels an ihm vorgesehener Kontaktfederabschnitte kontaktiert, dass die Raumbereiche elektromagnetisch voneinander entkoppelt sind

Durch die Anbringung dieses Trennelementes wird auf einfache Weise eine vollständige Entkopplung der beiden Raumbereiche erzielt. Die Raumbereiche - Hochvoltraumbereich und Niedervoltraumbereich - sind damit vollständig voneinander entkoppelt und die Leistungselektronikeinheit besonders verlässlich funktionierend.

Weitere vorteilhafte Ausführungsformen sind in den Unteransprüchen beansprucht und nachfolgend näher erläutert.

Sind das Trennelement so angeordnet und die Kontaktfederabschnitte mit dem Gehäuse und/oder der Platine so verbunden, dass sich je Raumbereich ein eigener faradayscher Käfig ausbildet, ist auch eine Abkoppelung nach außen effektiv umgesetzt. In diesem Zusammenhang ist es auch vorteilhaft, wenn das Gehäuse gesamtheitlich bereits einen faradayschen Käfig ausbildet.

Ist das Trennelement als Blech, vorzugsweise als Metallblech, weiter bevorzugt als Stahlblech, ausgebildet und/oder zumindest unmittelbarer Bestandteil eines der beiden faradayschen Käfige, vorzugsweise unmittelbarer Bestandteil beider faradayscher Käfige, so wird der Aufbau der Leistungselektronikeinheit besonders einfach gehalten. In diesem Zusammenhang ist es besonders vorteilhaft, wenn das Trennelement im Wesentlichen als (rechteckförmige) Platte, d.h. plattenförmig, ausgebildet ist. Dadurch nimmt das Trennelement besonders wenig Bauraum in Anspruch.

Bildet das Trennelement zumindest vier Kantenbereiche aus, an denen jeweils zumindest ein, bevorzugt mehrere, Kontaktfederabschnitt(e) angebracht ist/sind, ist das Trennelement zu möglichst vielen Seiten hin sicher elektrisch weiterverbunden.

In diesem Zusammenhang ist es besonders vorteilhaft, wenn zwei sich gegenüberliegende erste und zweite Kantenbereiche quer zu zwei sich gegenüberliegenden dritten und vierten Kantenbereichen ausgerichtet sind, wobei zumindest drei dieser Kantenbereiche das Gehäuse und einer dieser Kantenbereiche die Platine elektrisch leitend kontaktieren. Die Platine ist dann wiederum (mit einer dem Trennelement abgewandten Seite) weiter mit dem Gehäuse / der Gehäuseseite in elektrischem Kontakt. Somit sind die Raumbereiche sicher voneinander abgeschirmt.

Weiterhin ist es zweckmäßig, wenn die Kontaktfederabschnitte wiederum aus einem Blech, bevorzugt einem Metallblech, weiter bevorzugt einem Stahlblech, gefertigt sind. Dadurch wird die Fertigung der Kontaktfederabschnitte weiter vereinfacht.

Diesbezüglich ist es auch von Vorteil, wenn das Trennelement einstückig, bevorzugt stoffeinteilig, mit den Kontaktfederabschnitten ausgebildet ist, d.h. dass die Kontaktfederabschnitte ein einstückiger, vorzugsweise stoffeinteiliger Bestandteil des Trennelementes sind. Dadurch können die Kontaktfederabschnitte direkt aus dem gleichen Material wie das Trennelement ausgebildet werden. Insbesondere bei der Ausformung des Trennelementes aus einem Metallblech werden die Kontaktfederabschnitte dann in einem Verfahrensschritt direkt mit ausgeformt, d.h. umgebogen sowie zurechtgeschnitten.

Alternativ hierzu ist es jedoch auch möglich, die Kontaktfederabschnitte prinzipiell aus separaten Werkstücken, wie Metallblechen, zu fertigen und diese anschließend fest an das Trennelement anzubringen.

Insbesondere bei der einstückigen Ausbildung zwischen Trennelement und Kontaktfederabschnitten ist es weiter vorteilhaft, wenn das Trennelement sowie die Kontaktfederabschnitte eine einheitliche (Blech-)Dicke, vorzugsweise eine Dicke zwischen 0,02 mm und 1 mm, besonders bevorzugt um ca. 0,08 mm, aufweisen oder in ihrer Dicke variabel / unterschiedlich ausgestaltet sind. Insbesondere bei der einheitlichen Dickenausbildung wird der Herstellaufwand des Trennelementes weiter herabgesenkt. Bei Ausbildung des Trennelementes sowie der Kontaktfederabschnitte mit unterschiedlichen Dicken kann die Festigkeit der jeweiligen Bereiche individuell eingestellt werden.

Auch ist es zweckmäßig, wenn das Trennelement zumindest eine Verstärkungssicke aufweist, die vorzugsweise in Querrichtung, besonders bevorzugt in Längsrichtung verläuft. Bei einer ausschließlich längsverlaufenden / in Längsrichtung verlaufenden Verstärkungssicke, ist diese sie ohne entsprechendes Werkzeug produzierbar. Dadurch wird die Festigkeit des Trennelementes weiter verbessert. Die Versteifungssicke kann jedoch auch je nach Bedarf anders ausgeformt sein.

Weist das Trennelement zur Befestigung an dem Gehäuse und/oder an der Platine mehrere Befestigungslaschen auf, ist das Trennelement relativ zum Gehäuse an mehreren Punkten befestigbar.

Zudem ist es vorteilhaft, wenn sich die Platine durch einen zwischen dem Gehäuse und dem Trennelement ausgebildeten Spalt, unter elektrischer Kontaktierung des Trennelementes und/oder des Gehäuses, hindurch erstreckt. Dadurch werden der Aufbau sowie die Anzahl an Kontakten möglichst gering gehalten.

Desweiteren betrifft die Erfindung ein elektrisches Antriebssystem, etwa ein Hybridsystem (z.B. in Form eines Hybridmoduls), eine E-Achse oder ähnliche Ausführungen, für ein Kraftfahrzeug, insbesondere für einen Antriebsstrang des Kraftfahrzeuges, mit einer mit einem Elektromotor elektrisch verbundenen Leistungselektronikeinheit nach zumindest einer der zuvor beschriebenen Ausführungen. Die Leistungselektronik kann prinzipiell bei jedem elektrischen Antriebssystem im Fahrzeugbau eingesetzt sein (bevorzugt bei Plug-In Hybrid, 48V; Mild Hybrid; E-Achse, etc.).

In anderen Worten ausgedrückt, wird somit erfindungsgemäß durch ein Metallblech (Trennelement) eine elektromagnetische Entkopplung einer Hochvoltseite (Hochvoltraumbereich) von einer Niedervoltseite (Niedervoltraumbereich) einer Leistungselektronik realisiert. Hierbei wird insbesondere das Problem gelöst, eine elektromagnetische Beeinflussung zwischen der Hochvoltseite und der Niedervoltseite der Leistungselektronik zu vermeiden. Somit ist erfindungsgemäß eine Hochvoltseite von einer Niedervoltseite einer Leistungselektronik innerhalb eines Gehäuses eines elektrischen Antriebes, insbesondere zur Verwendung in einem Fahrzeug, elektromagnetisch durch ein Blech (aus Metall) getrennt, um dadurch Störungen entlang des Übertragungspfades zu vermeiden / zu reduzieren. Insbesondere werden durch die Verwendung des Bleches zwei faradaysche Käfige ausgebildet. Die Leistungselektronik ist an einer Platine ("printed circuit board" / PCB) vorgesehen, wobei ein erster Teil (Niedervoltseite) der Platine (erster Platinenbereich) in einem ersten faradayschen Käfig angeordnet ist und ein zweiter Teil (Hochvoltseite) der Platine (zweiter Platinenbereich) in einem zweiten faradayschen Käfig angeordnet sind. Das Blech weist Kontaktfedern (Kontaktfederabschnitte) auf, um das Blech mit dem Gehäuse des elektrischen Antriebs und/oder mit der Platine in Kontakt zu bringen.

Die Erfindung wird nun nachfolgend anhand von Figuren näher beschrieben, in welchem Zusammenhang auch prinzipiell verschiedene Ausführungsbeispiele erläutert sind.

Es zeigen:
- Fig. 1: eine Schnittdarstellung einer erfindungsgemäßen Leistungselektronikeinheit nach einem bevorzugten Ausführungsbeispiel im Bereich eines einen Hochvoltraumbereich von einem Niedervoltraumbereich eines Gehäuses der Leistungselektronikeinheit trennenden Trennelementes, wobei das Trennelement einerseits an einem Boden des Gehäuses, andererseits an einer sich zwischen den beiden Raumbereichen erstreckenden Platine kontaktierend anliegt,
- Fig. 2: eine isometrische Teilansicht der Leistungselektronikeinheit nach Fig. 1, in der besonders gut die gesamtheitliche Erstreckung des Trennelementes sowie dessen Anbringung in dem Gehäuse erkennbar sind, und
- Fig. 3: eine isometrische Darstellung des Trennelementes, wie es in den Fign. 1 und 2 eingesetzt ist, von einer Seite, an der sich mehrere Befestigungslaschen befinden und an der mehrere an dem Trennelement angebrachte Kontaktfederabschnitte gut erkennbar sind.

Die Figuren sind lediglich schematischer Natur und dienen ausschließlich dem Verständnis der Erfindung. Die gleichen Elemente sind mit denselben Bezugszeichen versehen.

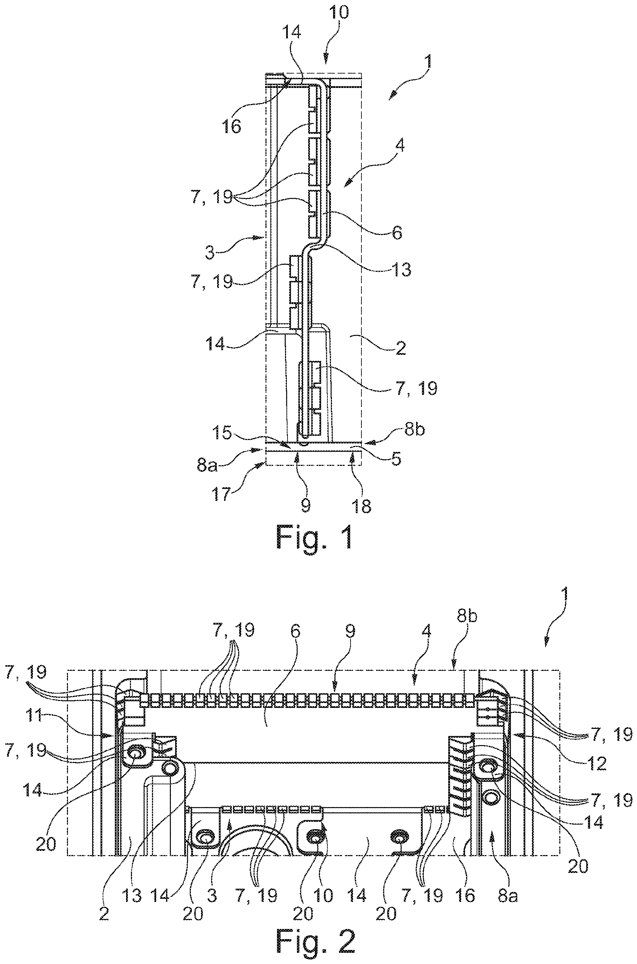

Eine Leistungselektronikeinheit 1 nach einem bevorzugten Ausführungsbeispiel ist in Fig. 1 in ihrem prinzipiellen Aufbau erkennbar. Die Leistungselektronikeinheit 1 ist im Betrieb bevorzugt in einem als Hybridmodul ausgebildeten Hybridsystem eines hybriden Antriebsstranges eines Kraftfahrzeuges eingebracht. Bevorzugt ist die Leistungselektronikeinheit 1 Bestandteil eines elektrischen Antriebs des Hybridsystems, der auch einen Elektromotor aufweist. Die Leistungselektronikeinheit 1 dient dazu, einen Elektromotor des Hybridmoduls mit elektrischer Energie zu versorgen bzw. elektrische Energie von diesem Elektromotor abzuführen.

Die Leistungselektronikeinheit 1 weist ein Gehäuse 2 auf, in dem wiederum eine hier der Übersichtlichkeit halber nicht vollständig dargestellte Leistungselektronik angeordnet ist. Das Gehäuse 2 nimmt prinzipiell mehrere, zu der Leistungselektronik zusammengesetzte elektronische Bauteile auf. Abschnittsweise ist in Fig. 1 eine Platine 5 dieser Leistungselektronik dargestellt. Das Gehäuse 2 ist wiederum in einen Niedervolt- / Niederspannungsraumbereich 3 sowie einen Hochvolt- / Hochspannungsraumbereich 4 aufgeteilt, wobei die Platine 5 in beide Raumbereiche 3 und 4 hineinragt. Die Platine 5 weist einen ersten Platinenbereich 17, der in dem Niedervoltraumbereich 3 angeordnet ist, sowie einen zweiten Platinenbereich 18 auf, der in dem Hochvoltraumbereich 4 angeordnet ist. Die Platine 5 ragt durch einen zwischen dem Trennelement 6 und dem Gehäuse 2 ausgebildeten Spalt 15.

Die beiden Raumbereiche 3 und 4 sind relativ zueinander elektrisch abgeschirmt. Hierzu dient unmittelbar ein Trennelement 6, das die beiden Raumbereiche 3 und 4 voneinander räumlich abtrennt. Das Trennelement 6 ist derart ausgestaltet und derart mit dem Gehäuse 2 verbunden, dass es sowohl das Gehäuse 2 als auch die Platine 5 elektrisch kontaktiert. Die Platine 5 kontaktiert dann wiederum das Gehäuse 2, bevorzugt an einer dem Trennelement 6 abgewandten Seite. Diese elektrische Kontaktierung des Trennelementes 6 mit dem Gehäuse 2 und der Platine 5 ist derart ausgeführt, dass sich die Raumbereiche 3 und 4 gegenseitig voneinander elektromagnetisch voneinander entkoppelt sind.

Da das Gehäuse 2 zudem bereits an sich einen eigenen faradayschen Käfig ausbildet, ist somit durch das Trennelement 6 je Raumbereich 3 und 4 wiederum ein eige-ner faradayscher Käfig 8a, 8b ausgebildet. Somit ist ein erster faradayscher Käfig 8a zur Verfügung gestellt, der durch das Gehäuse 2, die Platine 5 sowie das Trennelement 6, unter Ausbildung des Niedervoltraumbereiches 3, ausgebildet ist, sowie ein zweiter faradayscher Käfig 8b zur Verfügung gestellt, der durch das Gehäuse 2, die Platine 5 sowie das Trennelement 6 auf einer den Niedervoltraumbereich 3 abgewandten Seite, unter Ausbildung des Hochvoltraumbereiches 4, ausgebildet ist.

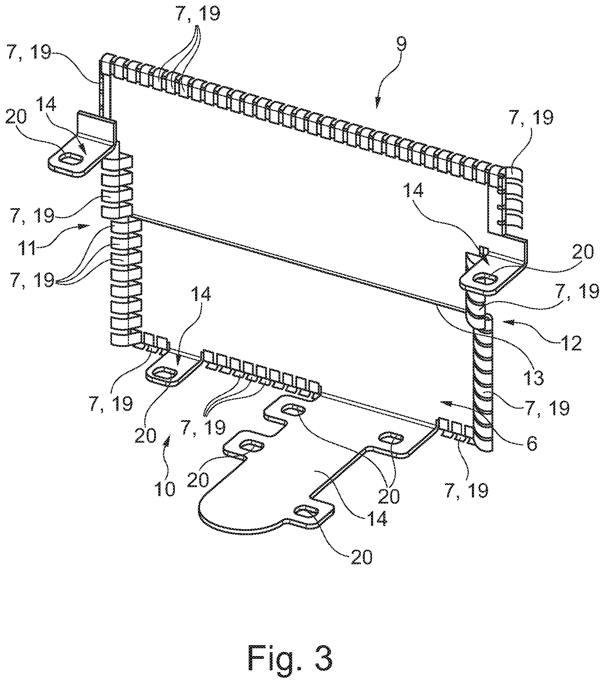

Das Trennelement 6 in alleiniger Betrachtung ist in der Fig. 3 veranschaulicht. Das Trennelement 6 ist in Form einer Platte aus einem (elektrisch leitenden) Metallblech gefertigt. Das Trennelement 6 bildet einen ersten Kantenbereich 9 und einen diesen ersten Kantenbereich 9 abgewandten sowie im Wesentlichen parallel zu dem ersten Kantenbereich 9 verlaufenden zweiten Kantenbereich 10 auf. Auch weist das Trennelement 6 zwei weitere Kantenbereiche 11 und 12 auf, wobei ein dritter Kantenbereich 11 einem vierten Kantenbereich 12 gegenüber liegt und sich im Wesentlichen wiederum parallel zu diesem erstreckt; gleichzeitig erstrecken sich die beiden dritten und vierten Kantenbereiche 11, 12 quer, nämlich senkrecht, zu den ersten und zweiten Kantenbereichen 9, 10. Es sind prinzipiell auch mehrere Kantenbereiche möglich, wobei diese Kantenbereiches nicht zwingend parallel bzw. senkrecht zueinander liegen. Es ist jedoch stets ein Kontakt des Trennelementes 6 an jedem der Kantenbereiche zum Gehäuse 2 hergestellt.

Zur Kontaktierung mit dem Gehäuse 2 bzw. mit der Platine 5, wie in Fig. 1 im Schnitt zu erkennen, liegen mehrere Kontaktfederabschnitte 7 seitens des Trennelementes 6 am Gehäuse 2 bzw. seitens der Platine 5 elektrisch leitend an. Jeder der Kantenbereiche 9 bis 12 weist mehrere Kontaktfederabschnitte 7 auf. Die Kontaktfederabschnitte 7 sind jeweils als lappenförmige, federelastische Vorsprünge 19 ausgeführt. Entlang des ersten Kantenbereiches 9 erstreckt sich benachbart sowie in Reihe zueinander eine Vielzahl von Kontaktfederabschnitten 7. Auch an dem zweiten Kantenbereich 10 sowie an den dritten und vierten Kantenbereichen 11 und 12 erstrecken sich jeweils mehrere Kontaktfederabschnitte 7 nebeneinander. Die Kontaktfederabschnitte 7 sind jeweils elektrisch an dem Trennelement 6 angebracht. Zudem ist erkennbar, dass sich die Kontaktfederabschnitte 7 an dem ersten Kantenbereich 9 zu einer ersten Plattenseite hin erstrecken, wohingegen sich die Kontaktfederabschnitte 7 an dem zweiten Kantenbereich 10 zu einer der ersten Plattenseite abgewandten zweiten Plattenseite hin erstrecken. An den beiden dritten und vierten Kantenbereichen 11 und 12 gibt es jeweils sowohl Kontaktfederabschnitte 7, die sich zu der ersten Plattenseite hin erstrecken, als auch Kontaktfederabschnitte 7, die sich zu der zweiten Plattenseite hin erstrecken. Somit ist das Trennelement 6 so angeordnet ist und die Kontaktfederabschnitte sind so mit dem Gehäuse 2 und der Platine verbunden / in Kontakt, dass sich je Raumbereich 3, 4 ein eigener faradayscher Käfig 8a, 8b ausbildet.

In Fig. 2 ist dann wiederum besonders gut die Anlage der jeweiligen Kontaktfederabschnitte 7 an dem Gehäuse 2 erkennbar. Zur Befestigung des Trennelementes 6 am Gehäuse 2 sind mehrere Befestigungslaschen 14 an dem Trennelement 6 ausgebildet. Die Befestigungslaschen 14 weisen jeweils zumindest ein Durchgangsloch 20 zum Durchführen eines Befestigungsmittels, wie einer Schraube, auf.

In Verbindung mit Fig. 1 ist zu erkennen, dass die beiden an dem zweiten Kantenbereich 10 angeordneten Befestigungslaschen 14 an einem Boden 16 des Gehäuses angebracht sind. Der erste Kantenbereich 9 liegt mit seinen Kontaktfederabschnitten 7 wiederum an einer Oberfläche, nämlich einer elektrisch leitenden Oberfläche der Pla-tine 5 an. Die Platine 5 ist mit einer dem ersten Kantenbereich 9 abgewandten Seite mit dem Gehäuse 2 elektrisch in Kontakt. Die beiden Kantenbereiche 11 und 12 liegen mit ihren Kontaktfederabschnitten 7 an einer Innenoberfläche von Gehäuseseitenwänden an.

Des Weiteren sei darauf hingewiesen, dass das Trennelement 6 eine Verstärkungssicke 13 aufweist, die sich zwischen den beiden dritten und vierten Kantenbereichen 11 und 12 erstreckt. Die Verstärkungssicke 13 dient zur Versteifung des plattenförmigen Trennelementes 6. Die Verstärkungssicke 13 kann jedoch auch anders ausgebildet sein. Die Verstärkungssicke 13 dient jedoch stets zur Versteifung.

In Fig. 3 ist veranschaulicht, dass die Kontaktfederabschnitte 7 in dem vorliegenden Ausführungsbeispiel separat vom Trennelement 6 hergestellt sind und an dem Trennelement 6 befestigt sind. Die Kontaktfederabschnitte 7 weisen eine geringere Dicke auf als das Trennelement 6. Auch die Kontaktfederabschnitte 7 sind aus Metallblech gefertigt. Die Kontaktfederabschnitte 7 weisen eine Dicke von ca. 0,08 mm auf. Trennelement 6 und Kontaktfederabschnitte 7 bilden eine Trenneinheit / Blecheinheit.

In anderen Ausführungsbeispielen sind die Kontaktfederabschnitte 7 jedoch auch einteilig / einstückig, d.h. stoffeinteilig, mit dem Trennelement 6 ausgebildet. In diesem Zusammenhang ist es besonders vorteilhaft, wenn die Kontaktfederabschnitte 7 zusammen mit dem Trennelement 6 aus einem Blech / Metallblech der gleichen (Blech-)Dicke bestehen / ausgeformt sind. Die Kontaktfederabschnitte 7 sind dann unmittelbar an dem Trennelement 6 herausgearbeitete Bereiche, die mittels Umformverfahren sowie Stanz- / Schneidverfahren hergestellt sind. Bei gleichen Dicken des Trennelementes 6 sowie der Kontaktfederabschnitte 7 ist es besonders vorteilhaft, wenn die (Blech-)Dicke um 0,08 mm beträgt. Auch können mehrere Bleche zum ausbilden des Trennelementes 6 eingesetzt werden, wobei die Bleche dann miteinander verbunden, etwa vernietet, sind.

In anderen Worten ausgedrückt, trennt erfindungsgemäß ein EMV-Blech (Trennelement 6) auf geringstem Bauraum die Hochvoltseite 4 von der Niedervoltseite 3 einer Leistungselektronik in einem Gehäuse 2 in zwei separate Faraday'sche Käfige 8a, 8b, in denen eine Platine 5 liegt. Dazu ist die Anordnung und Auswahl der passenden Kontaktfedern (Kontaktfederabschnitte 7) an das entsprechende Gehäuse 2 und die Platine 5 von Bedeutung. Des Weiteren wird das Blech 6 inklusive Kontaktfedern 7 in einem gefertigt.

Das EMV-Blech 6 kann an verschiedene Anforderungen angepasst werden. Zum einen kann die Geometrie des Blechs 6 an die entsprechende Kontur des Gehäuses 2 abgestimmt werden. Damit einhergehend ist die Auswahl der Kontaktfedern 7. Zur Steifigkeitserhöhung des Blechs 6 gegenüber Vibrationsanforderungen besteht die Möglichkeit eine Sicke (Verstärkungssicke 13) einzubringen. Das komplette EMV-Blech 6 besteht aus einem an das Gehäuse 2 geometrisch angepassten Blech 6 und den Kontaktfedern 7. Die Kontaktfedern 7 sind ringsum das Blech 6 verteilt und kon-taktieren zu drei Seiten 10, 11, 12 gegen das Gehäuse 2 und in eine Richtung 9 gegen die Platine 5. Die Platine 5 ragt in die beiden von dem EMV-Blech 6 räumlich getrennten Hoch- und Niedervoltbereiche 3, 4 rein. Auf der gegenüberliegenden Seite wird eine Kontaktierung vom Deckel 2 zur Platine 6 realisiert, um einen vollständig geschlossenen Faraday'schen Käfig 8a, 8b zu realisieren. In einer Ausführungsform ist das komplette EMV-Blech 6 inklusive Kontaktfedern 7 aus einem dünnen Blech 6 (beispielsweise wie die Dicke der Kontaktfedern 0,08 mm) ausgeführt. Dazu ist die entsprechende Kontur aus dem Blech 6 zu erzeugen. Anschließend erfolgt die Umformung der Federgeometrie zur Sicherstellung der Kontaktierung. Zur Versteifung kann nachfolgend ein dickeres Blech 6 zusammen genietet werden oder die Blechdi-cke variiert werden. Das EMV-Blech 6 / die Leistungselektronikeinheit 1 kommt bevorzugt in einem P2-Hybridsystem zum Einsatz, kann jedoch auch bei E-Achsen oder anderen Hybridsystemen / elektrischen Antriebssystemen zum Einsatz kommen.

### Bezugszeichenliste

- 1: Leistungselektronikeinheit
- 2: Gehäuse
- 3: Niedervoltraumbereich
- 4: Hochvoltraumbereich
- 5: Platine
- 6: Trennelement
- 7: Kontaktfederabschnitt
- 8a: erster faradayscher Käfig
- 8b: zweiter faradayscher Käfig
- 9: erster Kantenbereich
- 10: zweiter Kantenbereich
- 11: dritter Kantenbereich
- 12: vierter Kantenbereich
- 13: Verstärkungssicke
- 14: Befestigungslasche
- 15: Spalt
- 16: Boden
- 17: erster Platinenbereich
- 18: zweiter Platinenbereich
- 19: Vorsprung
- 20: Durchgangsloch

## Patentansprüche

1. Leistungselektronikeinheit (1), das aufweist:
ein elektrisch leitendes Gehäuse (2), in dem ein Niedervoltraumbereich (3) und ein Hochvoltraumbereich (4) ausgebildet sind,
eine Platine (5), die abschnittsweise sowohl in den Niedervoltraumbereich (3) als auch in den Hochvoltraumbereich (4) hineinragt, und
ein Trennelement (6), das derart in dem Gehäuse (2) angeordnet ist, dass die Raumbereiche (3, 4) elektromagnetisch voneinander entkoppelt sind,
**dadurch gekennzeichnet, dass**
das Trennelement das Gehäuse (2) oder die Platine (5) mittels an ihm vorgesehener Kontaktfederabschnitte (7) kontaktiert.

2. Leistungselektronikeinheit (1) nach Anspruch 1, **dadurch gekennzeichnet, dass** das Trennelement (6) so angeordnet ist und die Kontaktfederabschnitte (7) mit dem Gehäuse (2) oder der Platine (5) so verbunden sind, dass sich je Raumbereich (3, 4) ein eigener faradayscher Käfig (8a, 8b) ausbildet.

3. Leistungselektronikeinheit (1) nach Anspruch 1 oder 2, **dadurch gekennzeichnet, dass** das Trennelement (6) zumindest vier Kantenbereiche (9, 10, 11, 12) ausbildet, an denen jeweils zumindest ein Kontaktfederabschnitt (7) angebracht ist.

4. Leistungselektronikeinheit (1) nach Anspruch 3,
**dadurch gekennzeichnet, dass**
zwei sich gegenüberliegende erste und zweite Kantenbereiche (9, 10) quer zu zwei sich gegenüberliegenden dritten und vierten Kantenbereichen (11, 12) ausgerichtet sind, und
zumindest drei dieser Kantenbereiche (10, 11, 12) das Gehäuse (2) und einer dieser Kantenbereiche (9) die Platine (5) elektrisch leitend kontaktieren.

5. Leistungselektronikeinheit (1) nach einem der Ansprüche 1 bis 4, **dadurch gekennzeichnet, dass** die Kontaktfederabschnitte (7) aus Blech gefertigt sind.

6. Leistungselektronikeinheit (1) nach einem der Ansprüche 1 bis 5, **dadurch gekennzeichnet, dass** das Trennelement (6) einstückig mit den Kontaktfederabschnitten (7) ausgebildet ist.

7. Leistungselektronikeinheit (1) nach einem der Ansprüche 1 bis 6, **dadurch gekennzeichnet, dass** das Trennelement (6) und die Kontaktfederabschnitte (7) eine einheitliche Dicke, vorzugsweise eine Dicke zwischen 0,02mm und 1mm, besonders bevorzugt um 0,08mm, aufweisen oder in ihrer Dicke unterschiedlich ausgestaltet sind.

8. Leistungselektronikeinheit (1) nach einem der Ansprüche 1 bis 7, **dadurch gekennzeichnet, dass** das Trennelement (6) eine Verstärkungssicke (13) aufweist.

9. Leistungselektronikeinheit (1) nach einem der Ansprüche 1 bis 8, **dadurch gekennzeichnet, dass** sich die Platine (5) durch einen zwischen dem Gehäuse (2) und dem Trennelement (6) ausgebildeten Spalt (15) unter elektrischer Kontaktierung des Trennelements (6) oder des Gehäuses (2), hindurcherstreckt.

10. Elektrisches Antriebssystem für ein Kraftfahrzeug, mit einer mit einem Elekt-romotor elektrisch verbundenen Leistungselektronikeinheit (1) nach einem der Ansprüche 1 bis 9.

## Claims

1. A power electronics unit (1) having:
an electrically conductive housing (2) in which a low-voltage space region (3) and a high-voltage space region (4) are formed,
a printed circuit board (5), some sections of which protrude into into both the low-voltage space region (3) and the high-voltage space region (4), and
a separating element (6) which is arranged in the housing (2) in such a way that the space region (3, 4) are electromagnetically decoupled from each other,
**characterised in that**
the separating element makes contact with the housing (2) or the printed circuit board (5) by means of contact spring sections (7) provided on the separating element.

2. The power electronics unit (1) according to claim 1, **characterised in that** the separating element (6) is arranged and the contact spring sections (7) are connected to the housing (2) or the circuit board (5) such that each space region (3, 4) forms its own Faraday cage (8a, 8b).

3. The power electronics unit (1) according to claim 1 or 2, **characterised in that** the separating element (6) forms at least four edge regions (9, 10, 11, 12), on each of which at least one contact spring section (7) is attached.

4. The power electronics unit (1) according to claim 3,
**characterised in that**
two opposing first and second edge regions (9, 10) are aligned transversely to two opposing third and fourth edge regions (11, 12), and
at least three of these edge regions (10, 11, 12) make electrically conductive contact with the housing (2) and one of these edge regions (9) makes electrically conductive contact with the printed circuit board (5).

5. The power electronics unit (1) according to any one of claims 1 to 4, **characterised in that** the contact spring sections (7) are made of sheet metal.

6. The power electronics unit (1) according to any one of claims 1 to 5, **characterised in that** the separating element (6) is integrally formed with the contact spring sections (7).

7. The power electronics unit (1) according to any one of claims 1 to 6, **characterised in that** the separating element (6) and the contact spring sections (7) have a uniform thickness, preferably a thickness between 0.02 mm and 1 mm, particularly preferably around 0.08 mm, or are designed to have different thicknesses.

8. The power electronics unit (1) according to any one of claims 1 to 7, **characterised in that** the separating element (6) has a reinforcing bead (13).

9. The power electronics unit (1) according to any one of claims 1 to 8, **characterised in that** the printed circuit board (5) extends through a gap (15) formed between the housing (2) and the separating element (6) with electrical contacting of the separating element (6) or of the housing (2).

10. An electrical drive system for a motor vehicle, having a power electronics unit (1) according to any one of claims 1 to 9 which is electrically connected to an electric motor.

## Revendications

1. Unité électronique de puissance (1) comprenant :
un boîtier électroconducteur (2) dans lequel sont formés un espace à basse tension (3) et un espace à haute tension (4),
une platine (5) qui fait saillie par secteurs aussi bien dans l'espace à basse tension (3) que dans l'espace à haute tension (4) et
un élément de séparation (6) qui est disposé dans le boîtier (2) de telle sorte que les espaces (3, 4) soient découplés électromagnétiquement l'un de l'autre,
**caractérisée en ce que**
l'élément de séparation entre en contact avec le boîtier (2) ou la platine (5) au moyen de secteurs élastiques de contact (7) prévus sur celui-ci.

2. Unité électronique de puissance (1) selon la revendication 1, **caractérisée en ce que** l'élément de séparation (6) est disposé et les secteurs élastiques de contact (7) sont reliés au boîtier (2) ou à la platine (5) de telle sorte que chaque espace (3, 4) forme sa propre cage de Faraday (8a, 8b).

3. Unité électronique de puissance (1) selon la revendication 1 ou 2, **caractérisée en ce que** l'élément de séparation (6) forme au moins quatre espaces de bord (9, 10, 11, 12), sur chacun desquels au moins un secteur élastique de contact (7) est fixé.

4. Unité électronique de puissance (1) selon la revendication 3,
**caractérisée en ce que**
deux premier et deuxième espaces de bord opposés (9, 10) sont orientés transversalement à deux troisième et quatrième espaces de bord opposés (11, 12) et
au moins trois de ces espaces de bord (10, 11, 12) établissent un contact électroconducteur avec le boîtier (2) et un de ces espaces de bord (9) avec la platine (5).

5. Unité électronique de puissance (1) selon l'une quelconque des revendications 1 à 4, **caractérisée en ce que** le secteur élastique de contact (7) est usiné à partir d'une tôle.

6. Unité électronique de puissance (1) selon l'une quelconque des revendications 1 à 5, **caractérisée en ce que** l'élément de séparation (6) est formé d'une seule pièce avec les secteurs élastiques de contact (7).

7. Unité électronique de puissance (1) selon l'une quelconque des revendications 1 à 6, **caractérisée en ce que** l'élément de séparation (6) et les secteurs élastiques de contact (7) ont une épaisseur uniforme, de préférence une épaisseur comprise entre 0,02 mm et 1 mm, de manière particulièrement préférée autour de 0,08 mm ou sont conçus avec une épaisseur différente.

8. Unité électronique de puissance (1) selon l'une quelconque des revendications 1 à 7, **caractérisée en ce que** l'élément de séparation (6) comporte une nervure de renfort (13).

9. Unité électronique de puissance (1) selon l'une quelconque des revendications 1 à 8, **caractérisée en ce que** la platine (5) s'étend à travers une fente (15) formée entre le boîtier (2) et l'élément de séparation (6) lors du contact électrique de l'élément de séparation (6) ou du boîtier (2).

10. Système d'entraînement électrique pour un véhicule à moteur, comprenant une unité électronique de puissance (1) selon l'une quelconque des revendications 1 à 9 qui est reliée électriquement à un moteur électrique.
